# EUROPEAN PATENT SPECIFICATION

(11) **EP 4 643 427 B1**
(45) Date of publication and mention of the grant of the patent: **09.12.2026**
(21) Application number: 23720288.2
(22) Date of filing: 19.04.2023
(51) Int. Cl.: H02H 7/26, H02H 9/02, H02J 3/38

(54) **A PROTECTION METHOD FOR AN ELECTRICAL COLLECTION SYSTEM**
SCHUTZVERFAHREN FÜR EIN ELEKTRISCHES SAMMELSYSTEM
PROCÉDÉ DE PROTECTION POUR UN SYSTÈME DE COLLECTE ÉLECTRIQUE

(30) Priority: 30.03.2023 EP 23382304
(43) Date of publication of application: 05.11.2025
(73) Proprietor: Hitachi Energy Ltd, 8050 Zürich (CH)
(72) Inventor: YUAN, ChunMing, Beijing 100062 (CN); SIEMASZKO, Daniel, 1450 Ste-Croix (CH); IGLESIAS, Javier, 28037 Madrid (ES)
(74) Representative: Vossius & Partner Patentanwälte Rechtsanwälte mbB
(86) International application number: PCT/EP2023/060143
(87) International publication number: WO 2024/199683

(56) References cited:
- CN-A- 114 243 679
- US-A1- 2012 265 360
- US-A1- 2013 286 521
- US-A1- 2019 074 685

## Description

### Technical Field

The present invention relates to a method, controller, and an electrical collection system for protecting the electrical collection system.

### Background

In an electrical power collection system delivering a power from distributed energy resources (DERs) to an electrical grid, a fault causes numerous issues. A conventional solution of the fault clearance is to install DC circuit breakers in order to block the path through which the power is flowing. Such solution however not only increases the power losses during operation but is also cost ineffective.

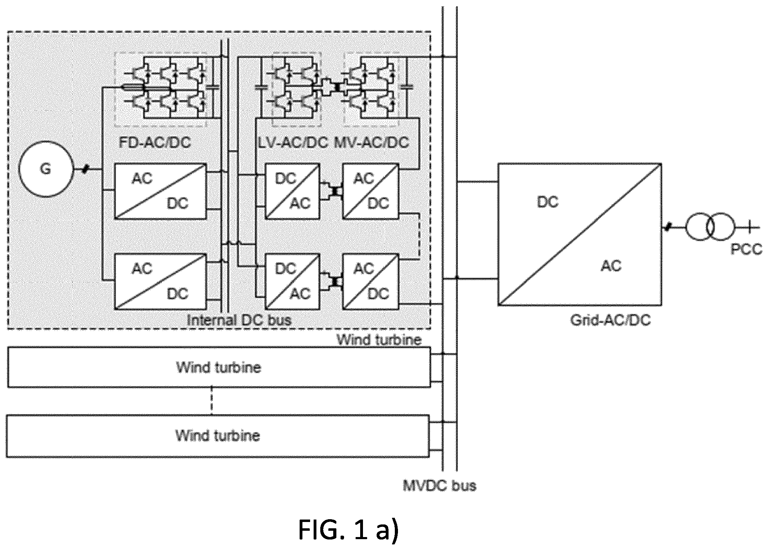

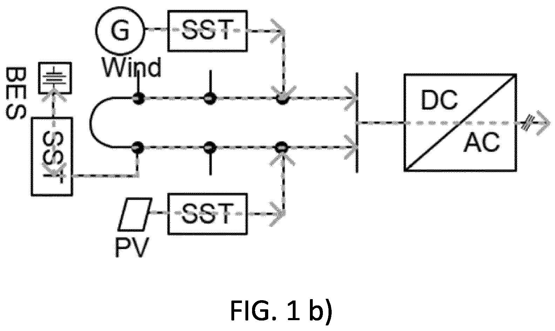

Fig. 1 a) illustrates a conventional medium voltage DC (MVDC) system for a windfarm application. In Fig. 1 a), the power is delivered from the wind turbines to an electrical grid through power converters and busses that are electrically coupling the wind turbines to the electrical grid. In particular, the grid AC/DC converter is electrically coupled to the electrical grid via a point of common coupling (PCC) and to the MVDC bus, and converts the power flow between the MVDC bus and the electrical grid. Each wind turbine comprises a generator and galvanic isolators. Such system may alternatively or further include any other DERs such as photovoltaic (PV) panels and battery energy storages (BES) for smooth power output. Fig. 1 b) illustrates a simplified block diagram of a conventional electrical power collection system. In such MVDC system, a short-circuit fault causes numerous issues and the conventional fault clearance solution increases power losses and is cost ineffective.

Examples of known protection schemes for electrical collection systems are disclosed in US 2019/074685, US 2013/286521, US 2012/265360 and CN 114 243 679.

Thus, there is a need to improve a method, controller, and an electrical collection system for protecting the electrical collection system.

### Summary

The present invention, as defined by the appended claims, relates to a method for protecting an electrical power collection system comprising an electrical grid being electrically coupled to an electrical branch, the electrical branch comprising a plurality of switches for connecting or disconnecting the electrical branch at respective positions on the electrical branch, wherein a distributed energy resource is electrically coupled to a node on the electrical branch, the method comprising: detecting a fault occurrence on the electrical branch based on a monitored voltage and/or current of the electrical branch; limiting, based on the detecting a fault occurrence, a power flow from the electrical branch to the electrical grid; adjusting, based on the detecting a fault occurrence, a voltage and/or current on the electrical branch; determining a fault location based on the adjusted voltage and/or current on the electrical branch; and disconnecting a portion of the electrical collection system based on the determined fault location.

In an embodiment, the limiting is or comprises limiting the power flow from the electrical branch to the electrical grid, in particular by controlling a bidirectional power valve electrically coupling the electrical branch to the electrical grid.

In an embodiment, the adjusting further comprises injecting a predetermined current to the electrical branch, in particular by controlling a galvanic isolator electrically coupling the distributed energy resource to the node, and a fault location is determined based on the adjusted current.

In an embodiment, the method further comprises limiting, prior to the disconnecting, a power flow from the distributed energy resource to the node, in particular by controlling the galvanic isolator electrically coupling the distributed energy resource to the node.

In an embodiment, the disconnecting is or comprises disconnecting at least the two switches of the plurality of switches, when having determined that a fault location resides on the branch between the at least two switches.

In an embodiment, the at least two switches of the plurality of switches are adjacent to each other, in particular having the node located between the at least two switches.

In an embodiment, two ends of the electrical branch are electrically coupled to a bidirectional power valve, being further electrically coupled to the electrical grid, forming a loop, and a power flows from the distributed energy resource to the electrical grid.

In an embodiment, the method further comprises re-operating the power collection system by: enabling, after the disconnecting, a power flow from electrical grid to the distribute energy resource, in particular by controlling the bidirectional power valve electrically coupling the electrical grid to the electrical branch.

The present invention, as defined by the appended claims, also relates to a controller for protecting an electrical power collection system comprising an electrical grid being electrically coupled to an electrical branch, the electrical branch comprising a plurality of switches for connecting or disconnecting the electrical branch at respective positions on the electrical branch, wherein a distributed energy resource is electrically coupled to a node on the electrical branch, the controller being configure to: detect a fault occurrence on the electrical branch based on a monitored voltage and/or current of the electrical branch; limit, based on the detecting a fault occurrence, a power flow from the electrical branch to the electrical grid; adjust, based on the detecting a fault occurrence, a voltage and/or current on the electrical branch; determine a fault location based on the adjusted voltage and/or current on the electrical branch; and disconnect a portion of the electrical collection system based on the determined fault location.

In an embodiment, the controller is further configured to perform the method according to any one of the embodiments disclosed herein.

The present invention further relates to an electrical power collection system comprises an electrical grid being electrically coupled to an electrical branch, the electrical branch comprising a plurality of switches for connecting or disconnecting the electrical branch at respective positions on the electrical branch, wherein a distributed energy resource is electrically coupled to a node on the electrical branch.

In an embodiment, the electrical power collection system further comprising the controller according to any one of the embodiments disclosed herein.

The method according to any one of the embodiments disclosed herein may advantageously monitor and/or estimate quantities for an industrial asset, such as operational performance, operational state, or information on external conditions or adjacent systems. One particular quantity to monitor and/or estimate is the state of health of an industrial asset, which allows the degradation of the asset to be understood, its remaining useful life (RUL) to be predicted, and decisions for operation, maintenance, and repair to be derived. The information thus obtained can be used for informing human operators, managers, or stakeholders, to support their operational or other decisions, or to partly or fully automate the operation of the asset. Various exemplary embodiments of the present disclosure are directed to providing features that will become readily apparent by reference to the following description when taken in conjunction with the accompanying drawings. In accordance with various embodiments, exemplary systems, methods, and devices are disclosed herein. It is understood, however, that these embodiments are presented by way of example and not limitation, and it will be apparent to those of ordinary skill in the art who read the present disclosure that various modifications to the disclosed embodiments can be made while remaining within the scope of the present claims.

Thus, the present disclosure is not limited to the exemplary embodiments and applications described and illustrated herein. Additionally, the specific order and/or hierarchy of steps in the methods disclosed herein are merely exemplary approaches.

In the following, exemplary embodiments of the present disclosure will be described. It is noted that some aspects of any one of the described embodiments may also be found in some other embodiments unless otherwise stated or obvious. However, for increased intelligibility, each aspect will only be described in detail when first mentioned and any repeated description of the same aspect will be omitted. Based upon design preferences, the specific order or hierarchy of steps of the disclosed methods or processes can be re-arranged while remaining within the scope of the present claims. Thus, those of ordinary skill in the art will understand that the methods and techniques disclosed herein present various steps or acts in a sample order, and the present disclosure is not limited to the specific order or hierarchy presented unless expressly stated otherwise.

The above and other aspects and their implementations are described in greater detail in the drawings, the descriptions, and the claims.

### Brief Description of the Drawings

Fig. 1 a) illustrates a conventional electrical power grid.
Fig. 1 b) illustrates a simplified diagram of a conventional electrical power grid.
Fig. 2 illustrates a flowchart of a method according to an embodiment of the present disclosure.
Fig. 3 a) illustrates an electrical power collection system according to an embodiment of the present disclosure under a normal operating condition.

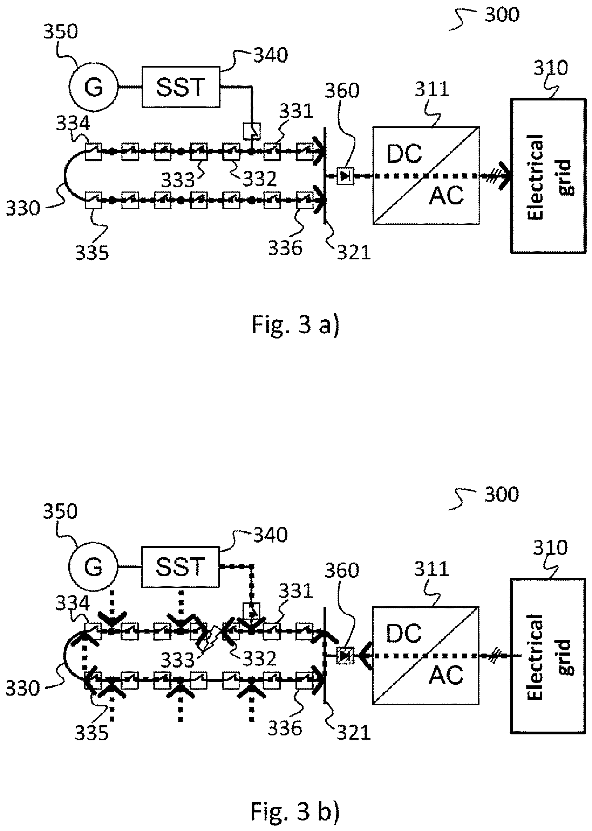

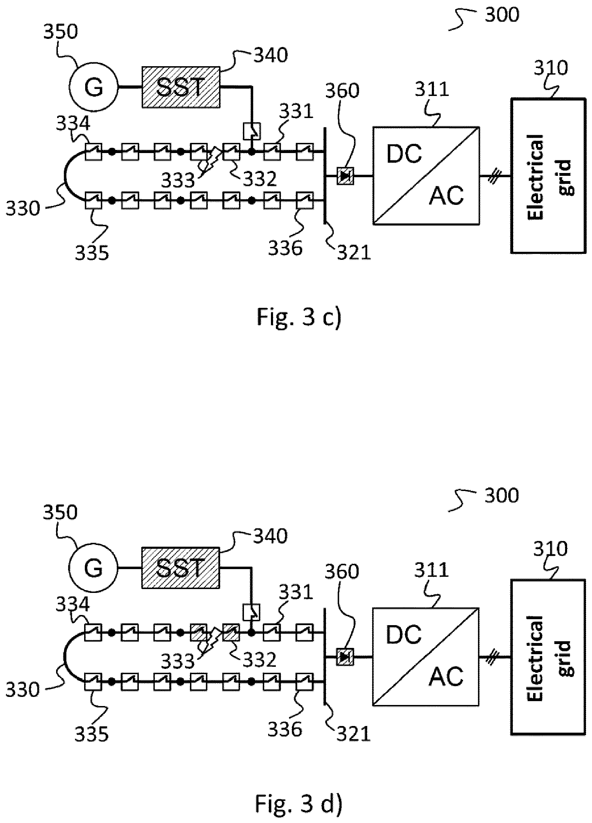

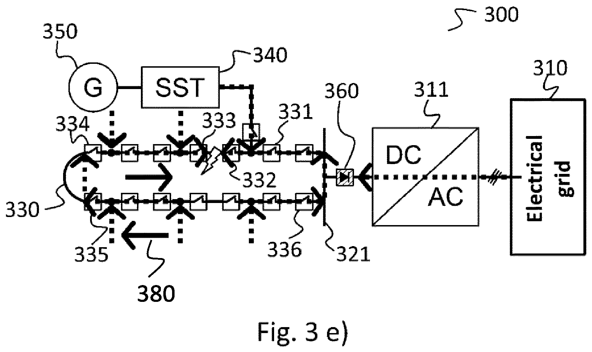

Fig. 3 b) illustrates an electrical power collection system according to an embodiment of the present disclosure under a fault condition.
Fig. 3 c) illustrates an electrical power collection system according to an embodiment of the present disclosure under a fault condition.
Fig. 3 d) illustrates an electrical power collection system according to an embodiment of the present disclosure under a fault condition.
Fig. 3 e) illustrates an electrical power collection system according to an embodiment of the present disclosure during a fault location process.

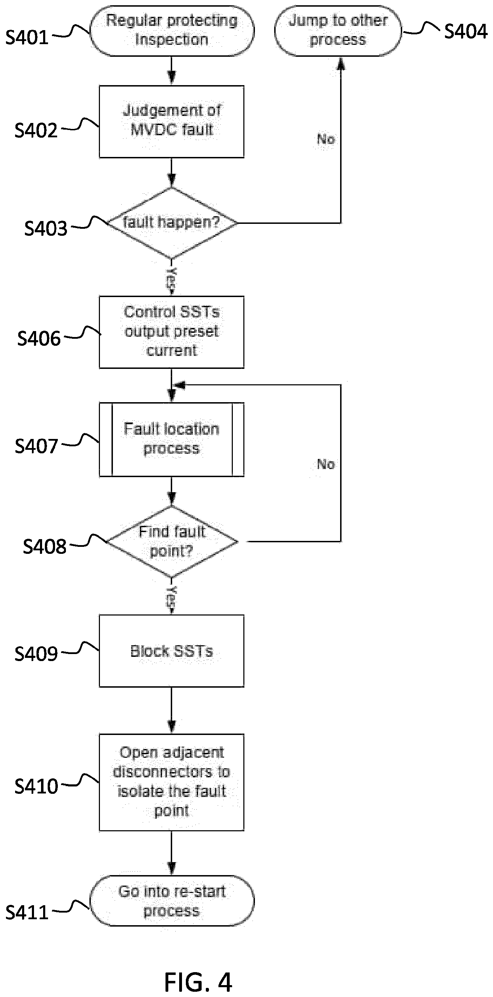

Fig. 4 illustrates a flowchart of a method according to an embodiment of the present disclosure.

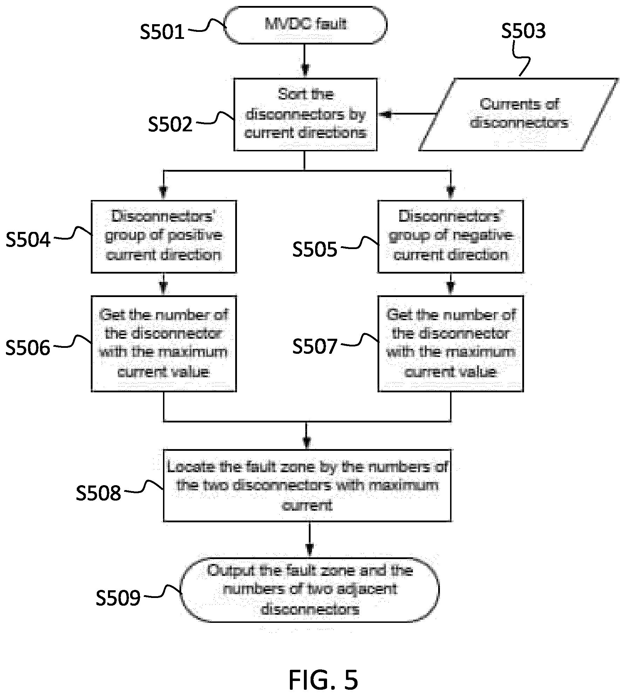

Fig. 5 illustrates a flowchart for a fault location determination method according to an embodiment of the present disclosure.

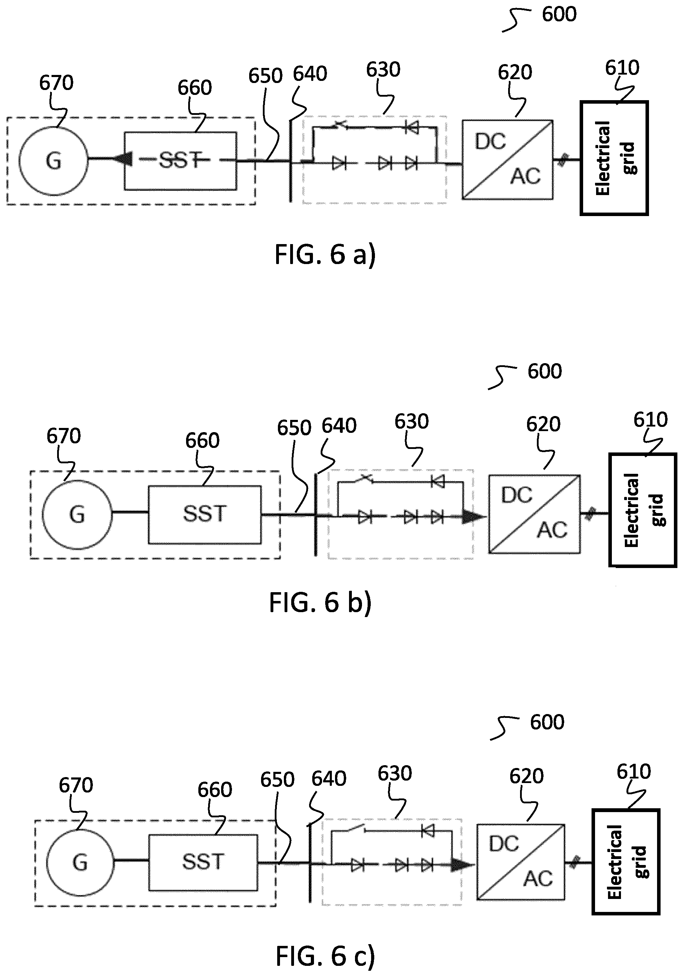

Fig. 6 a) illustrates a bidirectional power valve according to an embodiment of the present disclosure during a start-up or re-operation process.
Fig. 6 b) illustrates a bidirectional power valve according to an embodiment of the present disclosure after a start-up or re-operation process.
Fig. 6 c) illustrates a bidirectional power valve according to an embodiment of the present disclosure during a normal operating condition.

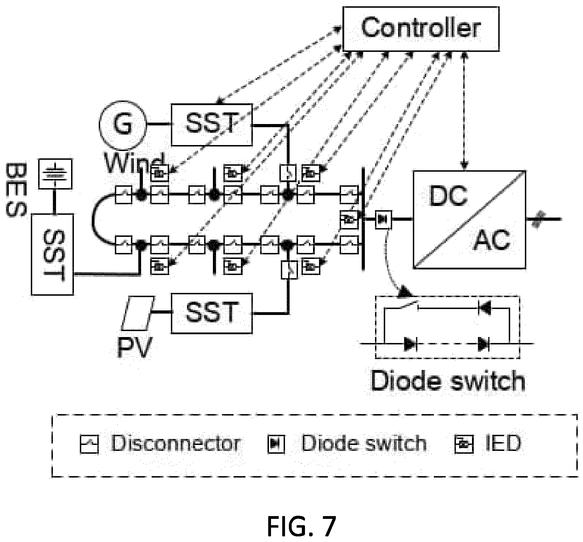

Fig. 7 illustrates an electrical power collection system according to an embodiment of the present disclosure.

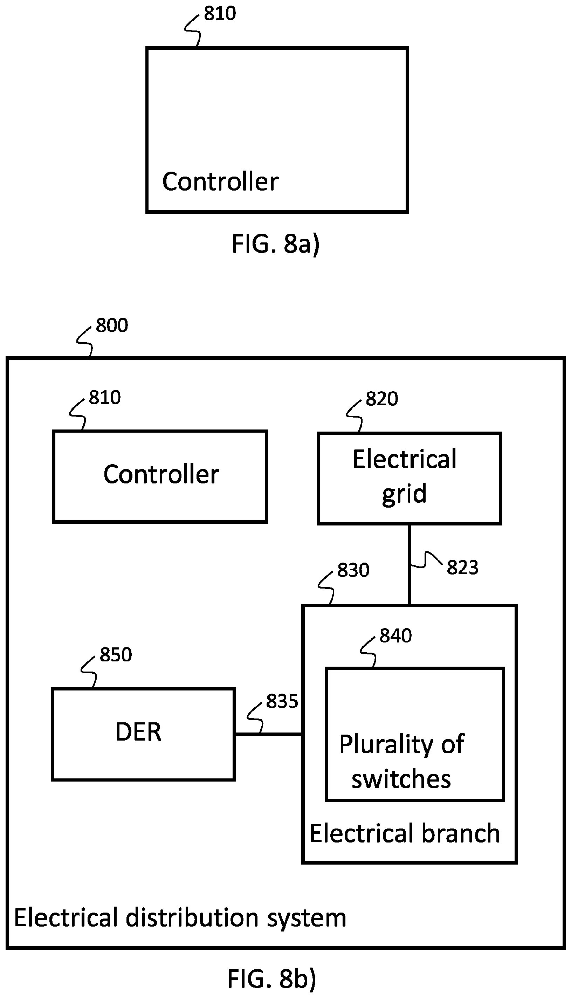

Fig. 8 a) illustrates a controller for an electrical power collection system according to an embodiment of the present disclosure.
Fig. 8 b) illustrates an electrical power collection system according to an embodiment of the present disclosure.

### Detailed Description of the Disclosure

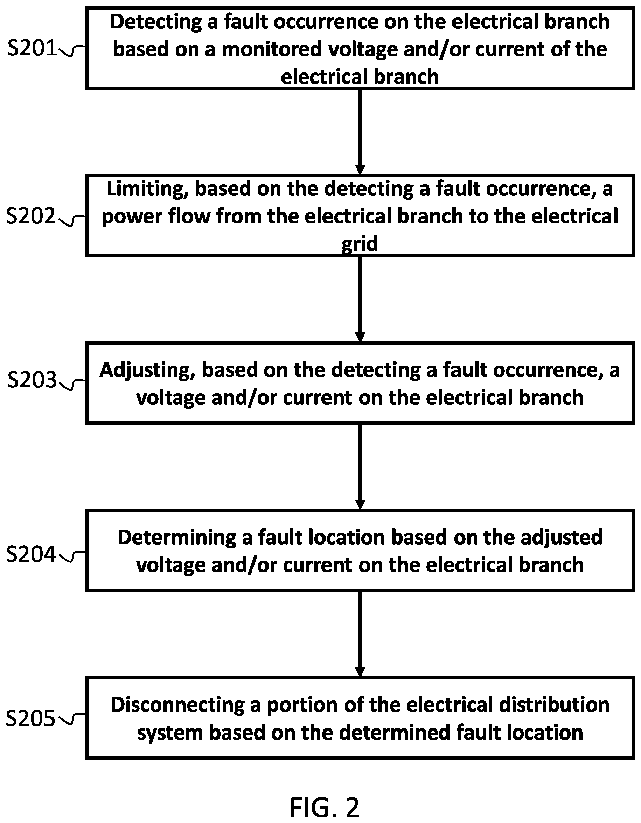

Fig. 2 illustrates a flowchart of a method according to an embodiment of the present disclosure. In particular, the method for protecting an electrical power collection system comprising an electrical grid being electrically coupled to an electrical branch, the electrical branch comprising a plurality of switches for connecting or disconnecting the electrical branch at respective positions on the electrical branch, wherein a distributed energy resource is electrically coupled to a node on the electrical branch. The electrical collection system may be equivalently referred to as an electrical power collection system.

At S201, a fault occurrence on the electrical branch is detected based on a monitored voltage and/or current of the electrical branch. The monitored voltage and/or current may be measured at any position on the electrical branch, in particular at any one of the respective positions of the plurality of switches. The detecting may be based on at least one of the voltage and/or current measured at any position on the electrical branch, in particular the voltage and/or current measured at the respective positions of the plurality of switches. The detecting may be further based on any other electrical or physical parameter of the electrical collection system and/or any components comprised therein.

At S202, a power flow from the electrical branch to the electrical grid is limited based on the detecting a fault occurrence. It is understood by the skilled person that the term 'limit' may be semantically equivalent to, thus can be interchangeably used with, other terms such as 'change', 'reduce', 'block', 'cut-off', or the like. In an embodiment, the limiting is or comprises controlling a bidirectional power valve, wherein the bidirectional power valve electrically couples the electrical branch to the electrical grid. In an embodiment, the limiting is performed after performing S201 and/or before performing S203. The limiting may be performed even when having determined that a fault has not occurred, for instance when a fault occurrence detection yields a false-negative response.

At S203, a voltage and/or current on the electrical branch is adjusted based on the detecting a fault occurrence. It is understood by the skilled person that the term 'adjust' may be semantically equivalent to, thus can be interchangeably used with, other terms such as 'setting', 'control', or the like. In an embodiment, the adjusting is or comprises injecting a predetermined current into the electrical branch, in particular by controlling a galvanic isolator, wherein the galvanic isolator electrically couples the distributed energy resource (DER) to the node. The term 'distributed energy resource' refers to any decentralized power source, e.g., generator, or power reserve, e.g., battery. In an embodiment, the adjusting is performed after performing S202 and/or before performing S204.

At S204, a fault location is determined based on the adjusted voltage and/or current on the electrical branch. The adjusted voltage and/or current may be measured at any position on the electrical branch, in particular at any one of the respective positions of the plurality of switches. A fault location may be a fault range, wherein a fault is located inside the fault range. In an embodiment, a fault range is determined by the adjusted voltage and/or current measured at at least two different positions, in particular the at least two different positions at which two different switches of the plurality of switches are respectively located, on the electrical branch, wherein the fault range is between the at least two different switches of the plurality of switches. In an embodiment, the determining a fault location is based on the adjusting the current on the electrical branch.

At S205, a portion of the electrical collection system is disconnected based on the determined fault location. In an embodiment, the disconnecting is or comprises disconnecting at least two switches of the plurality of switches, when having determined that a fault location resides on the branch between the at least two switches.

In an embodiment, the method further comprises limiting a power flow from the distributed energy resource to the node. The said limiting may be performed after performing S203 and/or before performing S205. The said limiting may be or comprise controlling the galvanic isolator, wherein the galvanic isolator electrically couples the distributed energy resource to the node.

In an embodiment, the method further comprises re-operating the power collection system by: enabling a power flow from electrical grid to the distribute energy resource. The re-operating may be performed after S205. In an embodiment, the enabling is or comprises controlling the bidirectional power valve electrically coupling the electrical grid to the electrical branch.

In an embodiment, the at least two switches of the plurality of switches are adjacent to each other, in particular having the node located between the at least two switches.

In an embodiment, two ends of the electrical branch are electrically coupled to a bidirectional power valve forming a loop, wherein the bidirectional power valve is further electrically coupled to the electrical grid via a power converter, and wherein a power flows from the distributed energy resource to the electrical grid. The loop may be a ring main unit.

In an embodiment, the plurality of switches are connecting the electrical branch at the respective positions thereof, in particular under a normal operating condition. In an embodiment, at least one of the plurality of switches are disconnecting the electrical branch at the respective positions thereof, in particular under a normal operating condition.

Herein, the term 'disconnector' may be interchangeably used with the term 'switch'.

Fig. 3 a) through Fig. 3 e) illustrate electrical collection systems according to embodiments of the present disclosure operating based on an exemplary method disclosed herein. In particular, the electrical power collection system 300 comprises an electrical grid 310 being electrically coupled to an electrical branch 330, wherein the electrical branch 330 comprises a plurality of switches 331, 332, 333, 334, 335, and 336 for connecting or disconnecting the electrical branch 330 at respective positions on the electrical branch 330, and wherein a distributed energy resource (i.e., a generator 350 in Fig. 3 a) through Fig. 3 e)) is electrically coupled to a node on the electrical branch 330. The node is positioned on the electrical branch between a second switch 331 and third switch 332 of the plurality of switches 331, 332, 333, 334, 335, and 336. For legibility, only a selection of the plurality of switches 331, 332, 333, 334, 335, and 336 are referred with the reference numerals in Fig. 3 a) through Fig. 3 e), and the numbering starts from the upper portion of the electrical branch 330 having one of the two ends being electrically coupled to the bus 321 and increases along the electrical branch towards the other end of the two ends of the electrical branch. The bus 321 may be any one of an electrical interconnection, an electrical bus, an electrical busbar, and a PCC. A set of two consecutive switches comprising a node to which a DER is electrically coupled to may be referred to as consecutive two switches. For instance, the second switch 331 and third switch 332 are two consecutive switches. The power converter 311 electrically couples the electrical grid 310 to the bidirectional power valve 360, wherein the bidirectional power valve is further electrically coupled to the bus 321 to which both ends of the electrical branch 330 are electrically coupled. The SST 340 electrically couples the DER to the node of the electrical branch 330.

Fig 3 a) illustrates an electrical power collection system according to an embodiment of the present disclosure under a normal operating condition. The term 'normal operating condition' refers to an abnormality-free operating condition and/or post-start or post-restart operating conditions. For instance, an abnormality may be a fault, e.g., short-circuit fault, on the electrical branch. For instance, an abnormality may be a failure in any of the electrical components comprised in the electrical collection system. Under normal operating condition, the plurality of switches 331, 332, 333, 334, 335, and 336 are connecting the electrical branch 330 at the respective positions thereof. Under normal operating condition, the powers generated by the generators 350 are delivered to the electrical grid 310 via the SST 340, bus 321, bidirectional power valve 360, and the power 311. Under normal operating condition, the bidirectional power valve 360 is controlled to act as a unidirectional power valve enabling only the power flow from the electrical branch 330 to the electrical grid 310. It is understood by the skilled person that the generated power may be delivered to another DER, e.g., BES, that is electrically coupled to the electrical branch. In an embodiment, the BES is controlled to provide the power to the electrical branch. Under normal operating condition, a fault occurrence on the electrical branch 330 is detected based on a monitored voltage and/or current of the electrical branch. The above-described method may be an embodiment of S201. Such fault occurrence detection may be performed iteratively. Once a fault on the electrical branch is detected, the electrical power collection system 300 performs the following method according to an embodiment of the present disclosure as illustrated in Fig. 3 b).

Fig. 3 b) illustrates an electrical power collection system according to an embodiment of the present disclosure under a fault condition. When a fault (illustrated with a thunder in Fig. 3 b) through Fig. 3 e)) occurs on the electrical branch between a third switch 332 and a fourth switch 333 of the plurality of switches 331, 332, 333, 334, 335, and 336 and the fault is detected, for instance according to S201, the power flow between the electrical branch 330 and the electrical grid 310 is limited by controlling the bidirectional power valve 360. It is noted that the exact fault location on the electrical branch may be undetermined at this stage, but a mere detection of a fault occurrence may suffice. The above-described method may be an embodiment of S202. Once the power flow between the electrical branch 330 and the electrical grid 310 is limited, the current on the electrical branch 330 may be adjusted by controlling the SST 340 to inject a pre-determined current into the electrical branch 330. The above-described method may be an embodiment of S203. Then, a fault location is determined based on the adjusted current on the electrical branch 330. The above-described method may be an embodiment of S204. While performing the above-described method, the plurality of switches 331, 332, 333, 334, 335, and 336 are connecting the electrical branch 330 at the respective positions thereof. Once the fault location is determined, the electrical power collection system 300 performs the following method according to an embodiment of the present disclosure as illustrated in Fig. 3 c).

Fig. 3 c) illustrates an electrical power collection system according to an embodiment of the present disclosure under a fault. Once the fault location is determined to reside between the second switch 331 and third switch 332 of the plurality of switches 331, 332, 333, 334, 335, and 336, the power flow from the generator 350 to the electrical branch 330 is limited by controlling the SST 340. While performing the above-described method, the plurality of switches 331, 332, 333, 334, 335, and 336 are connecting the electrical branch 330 at the respective positions thereof. Then, a fault point isolation method according to an embodiment of the present disclosure is performed as illustrated in Fig. 3 d).

Fig. 3 d) illustrates an electrical power collection system according to an embodiment of the present disclosure under a fault. When having determined that a fault is located between the third switch 332 and fourth switch 333 and the power flow from the generator 350 to the electrical branch 330 is controlled, a portion of the electrical branch is disconnected by opening the third switch 332 and fourth switch 333, i.e., disconnecting the electrical branch 330 at the respective positions of the third switch 332 and fourth switch 333. It is understood by the skilled person that in this embodiment, for an illustrative purpose, the two switches (i.e., the third switch 332 and fourth switch 333) that are most adjacent to the fault location are disconnected to isolate the fault, but it is possible to disconnect any portion of the electrical branch by controlling any combination of at least two switches of the plurality of switches 331, 332, 333, 334, 335, and 336 for the same purpose, as long as the fault resides within the selected combination of at least two switches. For instance, the third switch 332 and seventh switch 334 may be controlled to disconnect a portion of the electrical branch therebetween. The above-described method may be an embodiment of S205.

Fig. 3 e) illustrates an electrical power collection system according to an embodiment of the present disclosure during a fault location process. In particular, Fig. 3 e) illustrates an embodiment of S204 or the method shown in Fig. 3 b). When the bidirectional power valve 360 limits the power flow between the electrical branch 330 and the electrical grid, and the current on the electrical branch 330 is adjusted, the adjusted current in the electrical branch 330 flows towards the fault location between the third switch 332 and fourth switch 333. Defining an arbitrary current direction as a positive direction 380 allows to observe the current direction at plurality of measurement points, e.g., at the respective positions of the plurality of switches 331, 332, 333, 334, 335, and 336. In addition, starting from an arbitrary position on the electrical branch, the current accumulates along the conduction path towards the fault location, when the DERs inject current into the electrical branch 330 at multiple positions along said path. Thus, a fault location can be identified between a first measurement point recording the maximum current in the positive current direction and a second measurement point recording the maximum current in the negative current direction. The method illustrated in Fig. 4 may be implemented in combination with the electrical collection system illustrated in Fig. 3 a) through Fig. 3 e).

Fig. 4 illustrates a flowchart of a method according to an embodiment of the present disclosure. At S401, a regular protecting inspection is performed. At S402, an MVDC fault is determined. S402 may be equivalent to S201. At S403, a further action is decided based on the fault occurrence determined at S402. When a fault is not detected, the method jumps to other process (S404). In an embodiment, the other process of S404 may include the fault detection of S402. When a fault is detected, SST is controlled to output a pre-set current (S406) to adjust the electrical branch current. In an embodiment, prior to S406, a power flow between the electrical grid and electrical branch is limited. Then, at S407, a fault location process is executed, wherein a fault point is iteratively checked until determined (S408). In an embodiment, after a pre-defined number of iterations or a pre-defined period of time, the loop formed by S407, S408, and the negative result of S408 breaks and the method jumps to another block, for instance S409. In the same embodiment, after the pre-defined number of iterations or the pre-defined period of time, the fault point may be determined as a pre-defined location on the electrical branch. Blocks S405 through S408 may correspond to the method illustrated with the system shown in Fig. 3 b). Once a fault location is determined, the SST controlled at S406 is blocked to limit the power flow between the grid and the node (S409). S409 may correspond to the method illustrated with the system shown in Fig. 3 c). Then, the fault point is isolated by opening the adjacent switches (S410). S410 may correspond to the method illustrated with the system shown in Fig. 3 d). At S411, the system enters a re-start process. S411 may correspond to the method illustrated with the system shown in Fig. 3 e). The term 're-start' or 're-operate' refers to an action of controlling the relevant components comprised in a system to return to a normal operation, in particular after a protective measurement such as disconnecting a portion of the electrical branch is applied thereto.

Fig. 5 illustrates a flowchart for a fault location determination method according to an embodiment of the present disclosure. The method illustrated in Fig. 5 may be an embodiment of the fault location determination of S407 or the method shown in Fig. 3 e). When an MVDC fault is detected, the current on the electrical branch may be adjusted as illustrated in Fig. 3 b). At S503, the adjusted currents are measured at the respective positions of the plurality of switches on the electrical branch. The measured adjusted currents are sorted, by the current directions at S502, into a first group of disconnectors located at the respective positions through which the current flows in a defined positive direction (S504) and a second group of disconnectors located at the respective positions through which the current flows in a defined negative direction (S505). The numbering (in counting order) of the disconnectors which record the maximum current value among the first group and among the second group are identified at S506 and S507, respectively. Then, at S508, the fault zone is located by the numbers of the two disconnectors with maximum current. At S509, the fault zone and the numbers of two adjacent disconnectors are outputted for a further processing or signal generation.

Fig. 6 a) through Fig. 6 c) illustrate electrical power collection systems according to embodiments of the present disclosure during various processes and conditions. The electrical power collection system 600 is a simplified diagram of the electrical power collection system 300 illustrated in Fig. 3 a) through Fig. 3 e). That is, the electrical grid 610, power converter 620, bidirectional power valve 630, bus 640, electrical branch 650, SST 660, and generator 670 in Fig. 6 a) through Fig. 6 c) correspond to the electrical grid 310, power converter 311, power valve 360, bus 321, electrical branch 330, SST 340, and generator 350, respectively, illustrated in Fig. 3 a) through Fig. 3 e). In an embodiment, the power converter 620 and/or SST 660 enable bidirectional power transfer. The bidirectional power valve 630 comprises a first branch comprising a first plurality of diodes and a second branch comprising a second diode antiparallel to the first plurality of diodes, wherein the second branch further comprises a switch, for connecting or disconnecting the second branch, at a position succeeding the second diode in the direction of the current flow through the second diode when the second diode is forward biased. It is understood by the skilled person that the first branch of the bidirectional power valve may comprise only one diode.

Fig. 6 a) illustrates an electrical power collection system according to an embodiment of the present disclosure during a start-up or re-operation process. During the start-up or re-operation process, the switch comprised in the second branch is closed to enable the power flow from the electrical grid 610 to the generator 670 through the second branch of the bidirectional power valve 630. After such start-up or re-operation process, the power flows through the first branch as shown in Fig. 6 b). Fig. 6 b) illustrates an electrical power collection system according to an embodiment of the present disclosure after a start-up or re-operation process. After such start-up or re-operation process, the power is delivered from the generator 670 to the electrical grid 610 through the first branch comprised in the bidirectional power valve 630. It is noted that the switch in the second branch comprised in the bidirectional power valve 630 may still be connecting the second branch. Fig. 6 c) illustrates an electrical power collection system according to an embodiment of the present disclosure during a normal operating condition. Under normal operating condition, the switch in the second branch comprised in the bidirectional power valve 630 disconnects the second branch and the power is delivered from the generator 670 to the electrical grid 610 through the first branch comprised in the bidirectional power valve 630.

Fig. 7 illustrates an electrical power collection system according to an embodiment of the present disclosure. In particular, the electrical power collection system comprises the systems illustrated in Fig. 3 a) through Fig. 3 e) and further comprises a controller and a plurality of intelligent electronic devices (IEDs). The controller is configured to perform the method according to any one of the embodiments disclosed herein. The controller may be further configured to communicate, particularly bidirectionally, with any one of the components comprised in the system. In an embodiment, the controller receives or obtains measurements and/or signals and generate control and/or communication signals based on the received or obtained measurements and/or signals. Each of the plurality of IEDs may be or comprise a voltage and/or current sensor. Each of the plurality of IEDs may be located at the respective positions of the plurality of switches comprised in the electrical branch for connecting and disconnecting the electrical branch at said respective positions. It is understood by the skilled person that the number of the plurality of IEDs may be different from the number of the plurality of switches. The controller may be configured to control the plurality of switches. The plurality of IEDs may be configured to control the plurality of switches. The grid AC/DC converter may be or comprise a modular multilevel converter (MMC) with full-bridge cells as illustrated in Fig. 7. The MMC may comprise *m* full-bridge cells in a branch. In an embodiment, m is given as $n \leq m \leq ceil \left(\frac{\sqrt{6} {U}_{ac , max}}{{U}_{c , min}}\right)$ (1) wherein, n is a number of all cells in an electrical branch, *ceil*() is a function to round the element to the nearest integer towards infinity, *U_{ac,max}* is the maximum voltage of the AC grid, and *U_{c,min}* is the minimum voltage of the cells in operation, assuming that voltages of all the cells are same.

Fig. 8 a) illustrates a controller for an electrical power collection system according to an embodiment of the present disclosure. The controller 810 may be the controller illustrated in Fig. 7. In an embodiment, the controller 810 is further configured to perform the method according to any one of the embodiments disclosed herein. The controller 810 is a controller for protecting an electrical power collection system 800 comprising an electrical grid 820 being electrically coupled 823 to an electrical branch 830, the electrical branch 830 comprising a plurality of switches 840 for connecting or disconnecting the electrical branch 830 at respective positions on the electrical branch 830, wherein a distributed energy resource 850 is electrically coupled 835 to a node on the electrical branch 830, the controller being configure to: detect a fault occurrence on the electrical branch 830 based on a monitored voltage and/or current of the electrical branch 830; limit, based on the detecting a fault occurrence, a power flow from the electrical branch 830 to the electrical grid 820; adjust, based on the detecting a fault occurrence, a voltage and/or current on the electrical branch 830; determine a fault location based on the adjusted voltage and/or current on the electrical branch 830; and disconnect a portion of the electrical collection system 800 based on the determined fault location.

Fig. 8 b) illustrate an electrical power collection system according to an embodiment of the present disclosure. The electrical collection system 800 is an electrical power collection system comprising an electrical grid 820 being electrically coupled 823 to an electrical branch 830, the electrical branch 830 comprising a plurality of switches 840 for connecting or disconnecting the electrical branch 830 at respective positions on the electrical branch 830, wherein a distributed energy resource 850 is electrically coupled to a node on the electrical branch 830, the electrical collection system 800 further comprising the controller according to any one of the embodiments disclosed herein.

While various embodiments of the present disclosure have been described above, it should be understood that they have been presented by way of example only, and not by way of limitation. Likewise, the various diagrams may depict an example architectural or configuration, which are provided to enable persons of ordinary skill in the art to understand exemplary features and functions of the present disclosure. Such persons would understand, however, that the present disclosure is not restricted to the illustrated example architectures or configurations, but can be implemented using a variety of alternative architectures and configurations. Additionally, as would be understood by persons of ordinary skill in the art, one or more features of one embodiment can be combined with one or more features of another embodiment described herein. Thus, the breadth and scope of the present disclosure should not be limited by any of the above-described exemplary embodiments.

It is also understood that any reference to an element herein using a designation such as "first," "second," and so forth does not generally limit the quantity or order of those elements. Rather, these designations can be used herein as a convenient means of distinguishing between two or more elements or instances of an element. Thus, a reference to first and second elements does not mean that only two elements can be employed, or that the first element must precede the second element in some manner.

Additionally, a person having ordinary skill in the art would understand that information and signals can be represented using any of a variety of different technologies and techniques. For example, data, instructions, commands, information, signals, bits and symbols, for example, which may be referenced in the above description can be represented by voltages, currents, electromagnetic waves, magnetic fields or particles, optical fields or particles, or any combination thereof.

A skilled person would further appreciate that any of the various illustrative logical blocks, units, processors, means, circuits, methods and functions described in connection with the aspects disclosed herein can be implemented by electronic hardware (e.g., a digital implementation, an analog implementation, or a combination of the two), firmware, various forms of program or design code incorporating instructions (which can be referred to herein, for convenience, as "software" or a "software unit"), or any combination of these techniques.

To clearly illustrate this interchangeability of hardware, firmware and software, various illustrative components, blocks, units, circuits, and steps have been described above generally in terms of their functionality. Whether such functionality is implemented as hardware, firmware or software, or a combination of these techniques, depends upon the particular application and design constraints imposed on the overall system. Skilled artisans can implement the described functionality in various ways for each particular application, but such implementation decisions do not cause a departure from the scope of the present disclosure. In accordance with various embodiments, a processor, device, component, circuit, structure, machine, unit, etc. can be configured to perform one or more of the functions described herein. The term "configured to" or "configured for" as used herein with respect to a specified operation or function refers to a processor, device, component, circuit, structure, machine, unit, etc. that is physically constructed, programmed and/or arranged to perform the specified operation or function.

Furthermore, a skilled person would understand that various illustrative methods, logical blocks, units, devices, components and circuits described herein can be implemented within or performed by an integrated circuit (IC) that can include a general purpose processor, a digital signal processor (DSP), an application specific integrated circuit (ASIC), a field programmable gate array (FPGA) or other programmable logic device, or any combination thereof. The logical blocks, units, and circuits can further include antennas and/or transceivers to communicate with various components within the network or within the device. A general purpose processor can be a microprocessor, but in the alternative, the processor can be any conventional processor, controller, or state machine. A processor can also be implemented as a combination of computing devices, e.g., a combination of a DSP and a microprocessor, a plurality of microprocessors, one or more microprocessors in conjunction with a DSP core, or any other suitable configuration to perform the functions described herein. If implemented in software, the functions can be stored as one or more instructions or code on a computer-readable medium. Thus, the steps of a method or algorithm disclosed herein can be implemented as software stored on a computer-readable medium.

Computer-readable media includes both computer storage media and communication media including any medium that can be enabled to transfer a computer program or code from one place to another. A storage media can be any available media that can be accessed by a computer. By way of example, and not limitation, such computer-readable media can include RAM, ROM, EEPROM, CD-ROM or other optical disk storage, magnetic disk storage or other magnetic storage devices, or any other medium that can be used to store desired program code in the form of instructions or data structures and that can be accessed by a computer.

Additionally, memory or other storage, as well as communication components, may be employed in embodiments of the present disclosure. It will be appreciated that, for clarity purposes, the above description has described embodiments of the present disclosure with reference to different functional units and processors. However, it will be apparent that any suitable collection of functionality between different functional units, processing logic elements or domains may be used without detracting from the present disclosure. For example, functionality illustrated to be performed by separate processing logic elements, or controllers, may be performed by the same processing logic element, or controller. Hence, references to specific functional units are only references to a suitable means for providing the described functionality, rather than indicative of a strict logical or physical structure or organization.

Various modifications to the implementations described in this disclosure will be readily apparent to those skilled in the art, and the general principles defined herein can be applied to other implementations without departing from the scope of this disclosure. Thus, the disclosure is not intended to be limited to the implementations shown herein, but is to be accorded the widest scope consistent with the novel features and principles disclosed herein, as recited in the claims below.

## Claims

1. A method for protecting an electrical power collection system (300) comprising an
electrical grid (310) being electrically coupled to an electrical branch (330), the electrical branch comprising a plurality of switches (331.. 336) for connecting or disconnecting the electrical branch at respective positions on the electrical branch, wherein a distributed energy resource (350) is electrically coupled to a node on the electrical branch (330), the method comprising:
detecting a fault occurrence on the electrical branch based on a monitored voltage and/or current of the electrical branch;
limiting, based on the detecting a fault occurrence, a power flow from the electrical branch to the electrical grid;
adjusting, based on the detecting a fault occurrence, a voltage and/or current on the electrical branch;
determining a fault location based on the adjusted voltage and/or current on the electrical branch; and
disconnecting a portion of the electrical collection system based on the determined fault location,
wherein the disconnecting is or comprises disconnecting at least two switches of the plurality of switches, when having determined that a fault location resides on the branch between the at least two switches.

2. The method of claim 1, wherein the limiting is or comprises limiting the power flow from the electrical branch to the electrical grid, optionally by controlling a bidirectional power valve electrically coupling the electrical branch to the electrical grid.

3. The method of claim 1 or 2, wherein
the adjusting further comprises injecting a predetermined current to the electrical branch, optionally by controlling a galvanic isolator electrically coupling the distributed energy resource to the node, and
a fault location is determined based on the adjusted current.

4. The method of claim 3, further comprising limiting, prior to the disconnecting, a power flow from the distributed energy resource to the node, optionally by controlling the galvanic isolator electrically coupling the distributed energy resource to the node.

5. The method of any one of claims 1 to 4, wherein the at least two switches of the plurality of switches are adjacent to each other, optionally having the node located between the at least two switches.

6. The method of any one of claims 1 to 5, wherein
two ends of the electrical branch are electrically coupled to a bidirectional power valve, being further electrically coupled to the electrical grid, forming a loop, and
a power flows from the distributed energy resource to the electrical grid.

7. The method of any one of claims 1 to 6, further comprising re-operating the power collection system by:
enabling, after the disconnecting, a power flow from electrical grid to the distribute energy resource, optionally by controlling the bidirectional power valve electrically coupling the electrical grid to the electrical branch.

8. A controller for protecting an electrical power collection system (300) comprising an electrical grid (310) being electrically coupled to an electrical branch (330), the electrical branch comprising a plurality of switches (331...336) for connecting or disconnecting the electrical branch at respective positions on the electrical branch, wherein a distributed energy resource (350) is electrically coupled to a node on the electrical branch (330), the controller being configure to:
detect a fault occurrence on the electrical branch based on a monitored voltage and/or current of the electrical branch;
limit, based on the detecting a fault occurrence, a power flow from the electrical branch to the electrical grid;
adjust, based on the detecting a fault occurrence, a voltage and/or current on the electrical branch;
determine a fault location based on the adjusted voltage and/or current on the electrical branch; and
disconnect a portion of the electrical collection system based on the determined fault location,
wherein the controller is configured to disconnect at least two switches of the plurality of switches, when having determined that a fault location resides on the branch between the at least two switches.

9. The controller of claim 8, wherein the controller is further configured to perform the method according to any one of claims 2 to 7.

10. An electrical power collection system comprising an electrical grid being electrically coupled to an electrical branch, the electrical branch comprising a plurality of switches for connecting or disconnecting the electrical branch at respective positions on the electrical branch, wherein a distributed energy resource is electrically coupled to a node on the electrical branch, the electrical power collection system further comprising the controller of claim 8 or 9.

## Patentansprüche

1. Verfahren zum Schützen eines elektrischen Stromsammelsystems (300), das ein Stromnetz (310) umfasst, das elektrisch mit einem Stromzweig (330) gekoppelt ist, wobei der Stromzweig eine Mehrzahl von Schaltern (331.. 336) zum Verbinden oder Trennen des Stromzweigs an jeweiligen Positionen auf dem Stromzweig umfasst, wobei eine dezentrale Energiequelle (350) elektrisch mit einem Knoten auf dem Stromzweig (330) gekoppelt ist, wobei das Verfahren umfasst:
Detektieren eines Fehlerereignisses am Stromzweig basierend auf einer überwachten Spannung und/oder einem überwachten Strom des Stromzweigs;
Begrenzen, basierend auf dem Detektieren eines Fehlerereignisses, eines Leistungsflusses vom Stromzweig zum Stromnetz;
Anpassen, basierend auf dem Detektieren eines Fehlerereignisses, einer Spannung und/oder eines Stroms am Stromzweig;
Bestimmen einer Fehlerstelle basierend auf der angepassten Spannung und/oder dem angepassten Strom am Stromzweig; und
Trennen eines Teils des Stromsammelsystems basierend auf der bestimmten Fehlerstelle,
wobei das Trennen ein Trennen von mindestens zwei Schaltern der Mehrzahl von Schaltern ist oder umfasst, wenn bestimmt wurde, dass sich eine Fehlerstelle am Zweig zwischen den mindestens zwei Schaltern befindet.

2. Verfahren nach Anspruch 1, wobei das Begrenzen ein Begrenzen des Leistungsflusses von dem Stromzweig zu dem Stromnetz ist oder umfasst, optional durch Steuern eines bidirektionalen Leistungsventils, das den Stromzweig elektrisch mit dem Stromnetz koppelt.

3. Verfahren nach Anspruch 1 oder 2, wobei das Anpassen ferner das Einspeisen eines vorbestimmten Stroms in den Stromzweig umfasst, optional durch Steuern eines galvanischen Isolators, der die dezentrale Energieressource elektrisch mit dem Knoten koppelt, und eine Fehlerstelle basierend auf dem angepassten Strom bestimmt wird.

4. Verfahren nach Anspruch 3, ferner umfassend das Begrenzen, vor dem Trennen, eines Leistungsflusses von der dezentralen Energieressource zu dem Knoten, optional durch Steuern des galvanischen Isolators, der die dezentrale Energieressource elektrisch mit dem Knoten koppelt.

5. Verfahren nach einem der Ansprüche 1 bis 4, wobei die mindestens zwei Schalter der Mehrzahl von Schaltern aneinander angrenzen, wobei sich optional der Knoten zwischen den mindestens zwei Schaltern befindet.

6. Verfahren nach einem der Ansprüche 1 bis 5, wobei
zwei Enden des Stromzweigs elektrisch mit einem bidirektionalen Leistungsventil gekoppelt sind, das ferner elektrisch mit dem Stromnetz gekoppelt ist und eine Schleife bildet, und
eine Leistung von der dezentralen Energieressource zum Stromnetz fließt.

7. Verfahren nach einem der Ansprüche 1 bis 6, das ferner das erneute Betreiben des Stromsammelsystems umfasst, durch:
Aktivieren, nach dem Trennen, eines Leistungsflusses von dem Stromnetz zu der dezentralen Energieressource, optional durch Steuern des bidirektionalen Leistungsventils, das das Stromnetz elektrisch mit dem Stromzweig koppelt.

8. Steuereinrichtung zum Schützen eines Stromsammelsystems (300), das ein Stromnetz (310) umfasst, das elektrisch mit einem Stromzweig (330) gekoppelt ist, wobei der Stromzweig eine Mehrzahl von Schaltern (331...336) zum Verbinden oder Trennen des Stromzweigs an jeweiligen Positionen auf dem Stromzweig umfasst, wobei eine dezentrale Energiequelle (350) elektrisch mit einem Knoten auf dem Stromzweig (330) gekoppelt ist, wobei die Steuereinrichtung eingerichtet ist zum:
Detektieren eines Fehlerereignisses am Stromzweig basierend auf einer überwachten Spannung und/oder einem überwachten Strom des Stromzweigs;
Begrenzen, basierend auf dem Detektieren eines Fehlerereignisses, eines Leistungsflusses vom Stromzweig zum Stromnetz;
Anpassen einer Spannung und/oder eines Stroms am Stromzweig basierend auf dem Detektieren eines Fehlerereignisses;
Bestimmen einer Fehlerstelle basierend auf der angepassten Spannung und/oder dem angepassten Strom am Stromzweig; und
Trennen eines Teils des Stromsammelsystems basierend auf der bestimmten Fehlerstelle,
wobei die Steuereinrichtung dazu ausgebildet ist, mindestens zwei Schalter der Mehrzahl von Schaltern zu trennen, wenn bestimmt wurde, dass sich eine Fehlerstelle am Zweig zwischen den mindestens zwei Schaltern befindet.

9. Steuereinrichtung nach Anspruch 8, wobei die Steuereinrichtung ferner ausgebildet ist, um das Verfahren gemäß einem der Ansprüche 2 bis 7 durchzuführen.

10. Stromsammelsystem, das ein Stromnetz umfasst, das elektrisch mit einem Stromzweig verbunden ist, wobei der Stromzweig eine Mehrzahl von Schaltern zum Verbinden oder Trennen des Stromzweigs an jeweiligen Positionen auf dem Stromzweig umfasst, wobei eine dezentrale Energiequelle elektrisch mit einem Knoten auf dem Stromzweig verbunden ist, wobei das Stromsammelsystem ferner die Steuereinrichtung nach Anspruch 8 oder 9 umfasst.

## Revendications

1. Procédé de protection d'un système de collecte d'énergie électrique (300) comprenant un réseau électrique (310) couplé électriquement à une branche électrique (330), la branche électrique comprenant une pluralité d'interrupteurs (331.. 336) pour connecter ou déconnecter la branche électrique à des positions respectives sur la branche électrique, une ressource d'énergie distribuée (350) étant électriquement couplée à un nœud sur la branche électrique (330), le procédé comprenant :
la détection de la survenue d'un défaut sur la branche électrique en fonction d'une tension et/ou d'un courant surveillés de la branche électrique ;
la limitation, en fonction de la détection de la survenue d'un défaut, d'un flux d'énergie de la branche électrique vers le réseau électrique ;
l'ajustement, en fonction de la détection de la survenue d'un défaut, d'une tension et/ou d'un courant sur la branche électrique ;
la détermination d'un emplacement de défaut en fonction de la tension et/ou du courant ajustés sur la branche électrique ; et
la déconnexion d'une partie du système de collecte électrique en fonction de l'emplacement de défaut déterminé,
la déconnexion étant ou comprenant la déconnexion d'au moins deux interrupteurs de la pluralité d'interrupteurs, lorsqu'il a été déterminé que l'emplacement d'un défaut réside sur la branche entre les au moins deux interrupteurs.

2. Procédé selon la revendication 1, dans lequel la limitation est ou comprend la limitation du flux d'énergie de la branche électrique au réseau électrique, éventuellement en commandant une vanne d'énergie bidirectionnelle couplant électriquement la branche électrique au réseau électrique.

3. Procédé selon la revendication 1 ou 2, dans lequel l'ajustement comprend en outre l'injection d'un courant prédéterminé dans la branche électrique, éventuellement en commandant un isolateur galvanique couplant électriquement la ressource d'énergie distribuée au nœud, et
l'emplacement d'un défaut est déterminé en fonction du courant ajusté.

4. Procédé selon la revendication 3, comprenant en outre la limitation, avant la déconnexion, d'un flux d'énergie de la ressource d'énergie distribuée vers le nœud, éventuellement en commandant l'isolateur galvanique couplant électriquement la ressource d'énergie distribuée au nœud.

5. Procédé selon l'une quelconque des revendications 1 à 4, dans lequel les au moins deux interrupteurs de la pluralité d'interrupteurs sont adjacents l'un à l'autre, avec le nœud éventuellement situé entre les au moins deux interrupteurs.

6. Procédé selon l'une quelconque des revendications 1 à 5, dans lequel
deux extrémités de la branche électrique sont couplées électriquement à une vanne d'énergie bidirectionnelle, qui est en outre couplée électriquement au réseau électrique, formant une boucle, et
une énergie circule de la ressource d'énergie distribuée vers le réseau électrique.

7. Procédé selon l'une quelconque des revendications 1 à 6, comprenant en outre la remise en marche du système de collecte d'énergie par :
autorisation, après la déconnexion, d'un flux d'énergie du réseau électrique vers la ressource d'énergie distribuée, éventuellement en commandant la vanne d'énergie bidirectionnelle couplant électriquement le réseau électrique à la branche électrique.

8. Contrôleur de protection d'un système de collecte d'énergie électrique (300) comprenant un réseau électrique (310) couplé électriquement à une branche électrique (330), la branche électrique comprenant une pluralité d'interrupteurs (331..336) pour connecter ou déconnecter la branche électrique à des positions respectives sur la branche électrique, une ressource d'énergie distribuée (350) étant électriquement couplée à un nœud sur la branche électrique (330), le contrôleur étant configuré pour :
détecter la survenue d'un défaut sur la branche électrique en fonction d'une tension et/ou d'un courant surveillés de la branche électrique ;
limiter, en fonction de la détection de la survenue d'un défaut, un flux d'énergie de la branche électrique vers le réseau électrique ;
ajuster, en fonction de la détection de la survenue d'un défaut, une tension et/ou un courant sur la branche électrique ;
déterminer un emplacement de défaut en fonction de la tension et/ou du courant ajustés sur la branche électrique ; et
déconnecter une partie du système de collecte électrique en fonction de l'emplacement de défaut déterminé,
le contrôleur étant configuré pour déconnecter au moins deux interrupteurs de la pluralité d'interrupteurs, lorsqu'il a été déterminé que l'emplacement d'un défaut réside sur la branche entre les au moins deux interrupteurs.

9. Contrôleur selon la revendication 8, dans lequel le contrôleur est en outre configuré pour exécuter le procédé selon l'une quelconque des revendications 2 à 7.

10. Système de collecte d'énergie électrique comprenant un réseau électrique couplé électriquement à une branche électrique, la branche électrique comprenant une pluralité d'interrupteurs pour connecter ou déconnecter la branche électrique en des positions respectives sur la branche électrique, une ressource d'énergie distribuée étant couplée électriquement à un nœud sur la branche électrique, le système de collecte d'énergie électrique comprenant en outre le contrôleur selon la revendication 8 ou 9.
